Europäisches Patentamt

European Patent Office

Office européen des brevets

(19)

(11) Numéro de publication: **0 187 572 B1**

(12) **FASCICULE DE BREVET EUROPEEN**

(45) Date de publication du fascicule du brevet: **30.01.91**

(51) Int. Cl.⁵: **H 03 K 19/094,** H 03 K 19/017

(21) Numéro de dépôt: **85402394.2**

(22) Date de dépôt: **03.12.85**

(54) Circuit limiteur d'excursion des tensions logiques, et circuit logique comportant un tel limiteur d'excursion.

(30) Priorité: **04.12.84 FR 8418467**

(43) Date de publication de la demande:
**16.07.86 Bulletin 86/29**

(45) Mention de la délivrance du brevet:
**30.01.91 Bulletin 91/05**

(84) Etats contractants désignés:
**DE GB NL**

(73) Titulaire: **THOMSON-CSF
51, Esplanade du Général de Gaulle
F-92800 Puteaux (FR)**

(72) Inventeur: **Pham, Ngu Tung
THOMSON-CSF SCPI 173, bld Haussmann
F-75379 Paris Cedex 08 (FR)**

(74) Mandataire: **Taboureau, James et al
THOMSON-CSF SCPI
F-92045 Paris La Défense Cédex 67 (FR)**

(56) Documents cités:
FR-A-2 290 096
US-A-3 518 449
US-A-3 987 310
PATENTS ABSTRACTS OF JAPAN, vol. 7, no. 247 (E-208) 1392r, 2 novembre 1983, page 144 E 208; & JP - A - 58 136 139 (NIPPON DENKI K.K.) 13.08.1983
PATENTS ABSTRACTS OF JAPAN, vol. 1, no. 58, 6 juin 1977, page 67 E 77; & JP - A - 52 2270 (HITACHI SEISAKUSHO K.K.) 08.01.1977

(56) References cited:
PATENTS ABSTRACTS OF JAPAN, vol. 5, no. 86 (E-60) 758r, 5 juin 1981, page 131 E 60; & JP - A - 56 34 235 (NIPPON DENKI K.K.) 06.04.1981
EDN ELECTRICAL DESIGN NEWS, vol. 29, no. 3, juin 1984, pages 225-232, Boston, Massachusetts, US; J. HAIGHT: "GaAs logic characteristics result in integration problems"

Courier Press, Leamington Spa, England.

**Description**

La présente invention concerne un circuit limiteur de tension destiné aux circuits logiques à très faible consommation et ultra-rapides, la limitation de tension considérée concernant l'excursion de tension entre les niveaux bas et haut, ou 0 et 1 logiques.

Le circuit limiteur de tension selon l'invention concerne plus particulièrement les circuits logiques à transistors à effet de champ directement couplés, dits DCFL ou "Direct Coupled FET Logic", réalisés avec des transistors normalement bloqués, dont la tension de seuil est positive. Le circuit limiteur de tension est constitué par un transistor à effet de champ, de type normalement bloqué, dont la grille est réunie au drain, et qui est alimenté à travers une résistance connectée au drain.

Les circuits loqiques DCFL ont des performances d'autant meilleures que le courant de charge, dans la résistance qui alimente le transistor, est plus grand, mais dans ce cas la résistance du transistor à l'état passant augmente. Pour assurer un bon fonctionnement du circuit logique, il est préférable de choisir un courant de charge plus faible, et de compenser la perte de vitesse qui en résulte par une diminution du temps de commutation du circuit logique en diminuant l'excursion de tension entre les niveaux logiques bas et haut.

Cette limitation de l'excursion de tension est obtenue par un unique transistor à effet de champ, alimenté par son drain à travers une résistance de charge et dont la grille est réunie au drain, ce transistor et sa résistance de charge étant du même type et de mêmes caractéristiques que les transistors et leurs charges constituant le circuit logique controlé.

De façon plus précise, l'invention concerne un circuit limiteur d'excursion des tensions logiques dans les circuits logiques directement couplés, dits DCFL, comportant, connectés en série entre une source d'alimentation et la masse, une résistance de charge et un transistor à effet de champ dont la source est à la masse et dont la grille est reliée au drain, qui constitue le point de liaison entre le circuit logique et le circuit limiteur, celui-ci étant caractérisé en ce que la résistance de charge est une charge saturable constituée par un transistor sans métallisation de grille, dont le courant constant est limité à la moitié du courant maximum qui traverse le circuit logique DCFL.

L'invention sera mieux comprise par l'exposé de son fonctionnement, et celui d'un exemple d'application, ces exposés s'appuyant sur les figures jointes en annexe, qui représentent:

figure 1: schéma électrique du dispositif limiteur de tension selon l'invention;

figure 2: schéma électrique du dispositif limiteur de tension couplé à un inverseur logique;

figure 3: courbe des rapports d'excursions de tensions, avec et sans limiteur, en fonction de la tension de seuil du transistor;

figure 4: schéma d'une bascule RST$\overline{\overline{T}}$, munie de deux limiteurs de tension selon l'invention.

Les circuits logiques dits DCFL comprennent seulement un transistor à effet de champ, alimenté à partir d'une tension $V_{DD}$ par une résistance de charge. Dans ce type de logique, le transistor est obligatoirement normalement bloqué, à tension de seuil positive. La grille du transistor constitue l'entrée, et le point commun au drain et à la résistance de charge constitué la sortie du circuit.

Il est connue que les performances des circuits logiques DCFL classiques dépendent essentiellement — pour un type de transistor donné — du courant $I_C$ dans la charge: plus le courant est important, plus le circuit logique fonctionne vite.

Mais le courant $I_C$ est limité par la condition de compatibilité

$$V_B = R_{on} \cdot I_C \leqslant V_T$$

dans laquelle:

$V_B$ = niveau bas logique, également appelé tension de déchet,

$R_{on}$ = résistance du transistor à l'état passant (on),

$V_T$ = tension de seuil du transistor.

Pour qu'une bascule logique à transistor normalement bloqué fonctionne, il est évident qu'il faut que le niveau bas logique $V_B$ soit inférieur à la tension de seuil $V_T$ qui débloque le transistor.

Pour augmenter le courant de charge $I_C$ — ce qui augmente la vitesse du circuit logique — on peut augmenter la tension de seuil $V_T$, ce que l'on sait faire au cours de la fabrication du transistor, par exemple par une plus faible épaisseur de canal sous la grille. Mais la résistance $R_{on}$ augmente lorsque la tension de seuil $V_T$ croite, ce qui amène à des conditions contradictoires.

Il est préférable de choisir un courant de charge $I_C$ qui soit inférieur à sa valeur d'optimisation, c'est-à-dire celle qui communique la plus grande vitesse au circuit DCFL. De cette façon, la tension $V_B$ du niveau bas logique reste inférieure à la tension de seuil $V_T$ et, si l'on n'est pas obligé de choisir une tension de seuil élevée, pour des raisons technologiques par exemple, la résistance $R_{on}$ peut être très faible. L'avantage est que le rendement de fabrication de circuits intégrés à faible tension de seui $V_T$ et faible courant de charge $I_C$ est bien meilleur.

La perte admise sur la vitesse, en raison d'un courant de charge faible, est compensée par un gain sur le temps de commutation. Le temps de commutation $t_{pd}$ d'un circuit DCFL est, au premier ordre, donné par l'approximation

$$t_{pd} \simeq \frac{C.\Delta V}{I_C}$$

dans laquelle:

C = capacité de la charge du transistor

$\Delta V = V_H - V_B$ = excursion des tensions de niveaux logiques haut ($V_H$) et bas ($V_B$)

$I_C$ = courant de charge

Dans les circuits DCFL classiques:

$$V_H \simeq V_D \simeq 1 \text{ volt}$$

$V_D$ étant la tension de seuil de la diode Schottky qui forme une grille de transistor.

Si le courant de charge $I_C$ doit être faible, on peut compenser la perte en vitesse du circuit DCFL par une réduction du temps de commutation $t_{pd}$ en réduisant l'excursion de tension $\Delta V$.

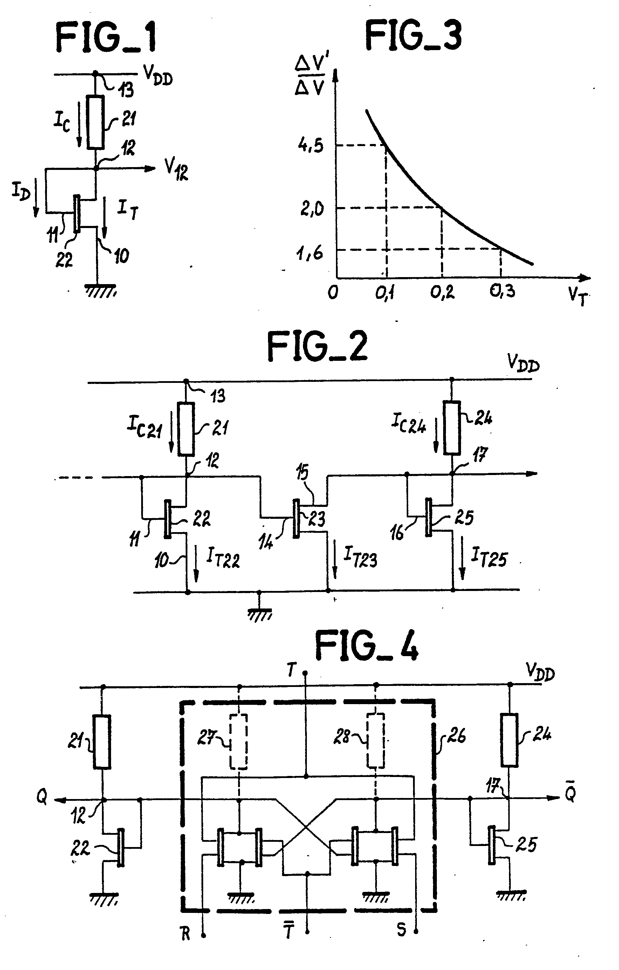

C'est l'objet de la présente invention que de proposer un circuit qui limite l'excursion de tension des niveaux logiques, représenté en figure 1.

Le circuit limiteur de tension selon l'invention comporte une charge 21 connectée en série avec un transistor 22. La charge 21 est une charge saturable telle qu'un transistor à effet de champ sans grille. Le transistor 22 est à grille Schottky et normalement bloqué, la grille 11 du transistor est connectée au drain, en un point 12, et la source 10 du transistor est à la masse du circuit. La résistance de charge 21 est connectée entre le drain 12 et un point 13 d'une alimentation $V_{DD}$.

Le courant $I_{C21}$ qui traverse la résistance de charge 21 se partage en un courant $I_{T22}$ qui traverse le transistor 22 et un courant $I_D$ qui passe par la diode Schottky de la grille 11, et on peut écrire que:

$$I_{T22} = g_{m22} (V_{12} - V_T) \tag{Equation 1}$$

où:

$$g_{m22} \simeq \frac{1}{R_{on}} = \text{transconductance du transistor 22}$$

$V_{12}$ = tension drain-source du transistor

$V_T$ = tension de seuil du transistor

Si la tension $V_{12}$ sur le drain est inférieure ou égale à la tension de seuil $V_D$ de la diode Schottky de grille

$$V_{12} \leqslant V_D \tag{Equation 2}$$

mais est cependant supérieure à la tension de seuil $V_T$ du transistor, alors il n'y a pas de courant $I_D$ qui passe par la grille 11

$$I_D = 0 \tag{Equation 3}$$

et dans ce cas le courant $I_{T22}$ qui traverse le transistor 22 est égal au courant $I_{C21}$ qui traverse la charge 21

$$I_{T22} = I_{C21} = g_{m22} (V_{12} - V_T) \tag{Equation 4}$$

on en tire:

$$V_{12} = \frac{I_{C21}}{g_{m22}} + V_T \tag{Equation 5}$$

La tension $V_{12}$ sur le drain, qui reste inférieure ou égale a la tension $V_D$ (équation 2) sera d'autant plus faible que le courant de charge $I_{C21}$ est plus faible.

Considérons maintenant, en figure 2, un inverseur logique constitué par un transistor 23, dont la source est à la masse. La grille 14 de ce transistor 23 est reliée au drain 12 du transistor 22 d'un premier circuit limiteur de la figure 1: la grille 14 reçoit donc la tension $V_{12}$. Le drain 15 du transistor 23 est relié au drain 17 d'un transistor 25 d'un second circuit limiteur selon la figure 1.

Les trois transistors 22, 23 et 25 étant intégrés simultanément, ainsi que les résistances de charge 21 et 24 des premier et second circuits limiteurs, on impose que les transistors ont même tension de seuil et que les résistances de charge sont identiques. Si le circuit n'est pas intégré mais réalisé en éléments discrets, cette condition reste valable.

Le potentiel $V_{12}$ étant appliqué sur la grille 14 du transistor 23, le courant $I_{T23}$ dans ce transistor est:

$$I_{T23} = g_{m22}(V_{12} - V_T) \qquad \text{Equation 6}$$

la tension de seul $V_T$ étant la même pour les transistors 22, 23 et 24.

D'après la relation 4, on peut écrire:

$$V_{12} - V_T = \frac{I_{C21}}{g_{m22}} = \frac{I_{T23}}{g_{m23}}$$

ou encore :

$$\frac{I_{T23}}{I_{C21}} = \frac{g_{m23}}{g_{m22}} = \frac{g_{m23}}{g_{m25}} = \frac{I_{T23}}{I_{C24}} \qquad \text{Equation 7}$$

puisque les transistors 22 et 25 sont identiques et les résistances de charge 21 et 24 identiques.

Pour que la résistance de charge 24 du second circuit limiteur soit compatible avec le transistor 23 — qu'elle complète pour former un inverseur — on impose la condition:

$$\frac{I_{T23max}}{I_{C24}} = \frac{g_{m23}}{g_{m25}} \geqslant 2 \qquad \text{Equation 8}$$

Cette condition peut se lire ainsi: on impose que, dans les conditions de fonctionnement de l'invention, le courant $I_{C24}$ dans la résistance de charge 24 est toujours inférieur ou égal à la moitié du courant de saturation $I_{T23}$ dans le transistor 23.

Dans ce cas, la tension de déchet ou tension de niveau bas logique $V_B$ du transistor 23, chargé par la résistance 24, est alors

$$V_B = R_{on23} \cdot I_{C24} \simeq \frac{1}{g_{m23}} \cdot I_{C24} \qquad \text{Equation 9}$$

mais d'après la relation 6

$$\frac{1}{g_{m23}} = \frac{V_{12} - V_T}{I_{T23}}$$

$$\text{donc} \quad V_B \simeq \frac{I_{C24}}{I_{T23}}(V_{12} - V_T)$$

Etant donné qu'on a imposé

$$\frac{I_{T23max}}{I_{C24}} \geqslant 2 \text{ soit} \qquad \frac{I_{C24}}{I_{T23max}} \leqslant \frac{1}{2}$$

il s'ensuit que

$$V_B \leqslant \tfrac{1}{2}(V_{12} - V_T)$$

La condition $V_B \leqslant V_T$ de compatibilité des niveaux logiques devient

$$\frac{V_{12} - V_T}{2} \leqslant V_T \text{ soit } V_{12} \leqslant 3_{VT} \qquad \text{Equation 11}$$

Cette condition est facilement satisfaite en choisissant le courant $I_{C24}$ assez faible. D'après l'équation 5, et parce que les transistors 22 et 25 et les charges 21 et 24 sont identiques, respectivement,

$$V_{12} = \frac{I_{C24}}{g_{m25}} + V_T \leqslant 3V_T$$

$$I_{C24} \leqslant 2\, g_{m25}\, V_T \qquad\qquad \text{Equation 12}$$

soit, à cause de la condition de l'équation 8

$$I_{C24} \leqslant g_{m23}\, V_T \qquad\qquad \text{Equation 13}$$

Le cas limite d'un circuit logique muni du limiteur d'excursion de tension est

$$V_B = V_T$$

soit

$$V_{12} = 3V_T$$

et l'excursion $\Delta V$ des tensions de niveaux logiques est

$$\Delta V = V_H - V_B = V_{12} - V_B = 2V_T$$

Si l'on compare ce résultat avec celui d'un circuit logique connu, non muni d'un limiteur d'excursion de tensions, et dans lequel

$$V_B = V_T$$

et

$$V_H = V_D$$

l'excursion de tension est

$$\Delta V' = V_D - V_T$$

Le rapport des excursions de tensions, sans et avec limiteur, est

$$\frac{\Delta V'}{\Delta V} = \frac{V_D - V_T}{2\, V_T}$$

La figure 3 représente la courbe de ce rapport des excursions de tension, en prenant, à titre d'application, $V_D = 1$ volt. Lorsque la tension de seuil $V_T$ d'un transistor varie de +0,1 volt à +0,3 volt, le rapport $\Delta V'/\Delta V$ varie de 4,5 à 1,6. Cette courbe et ces résultats montrent que le limiteur d'excursion de tensions selon l'invention est particulièrement intéressant pour les transistors à tension de seuil $V_T$ positive et voisine de 0 volt.

Les circuits logiques DCFL munis du limiteur d'excursion de tensions selon l'invention ont des performances beaucoup plus élevées que ceux qui n'en sont pas munis. En effet, pour un transistor 23 faisant partie d'un circuit logique, le temps de montée $t_r$ est donné par

$$t_r = \frac{C \cdot \Delta V}{I_{C24}}$$

Le temps de descente $t_f$ est donné par

$$t_f = \frac{C \cdot \Delta V}{I_{T23max} - I_{C24}}$$

et le temps de commutation $t_{pd} = t_r + t_f$ est proportionnel à

$$t_{pd} \frac{C \cdot \Delta V}{I_{T23max} - I_{C24}} + \frac{C \cdot \Delta V}{I_{C24}}$$

Ce temps de commutation est d'autant plus petit que $\Delta V$ est plus petit.

Le cas qui vient d'être exposé correspond au cas limité où

$$I_{C24} = g_{m23} \cdot V_T \qquad\qquad \text{Equation 13}$$

Si l'on choisit un courant de charge inférieur aux valeurs limites, c'est-à-dire

$$I_{C24} < g_{m23} \cdot V_T$$

Le rapport $\Delta V'/\Delta V$ est encore plus grand, ce qui compense la diminution de performances liée à un courant de charge faible.

Ainsi, la limitation des excursions de tensions logiques permet d'obtenir des circuits DCFL de performances très intéressantes, avec beaucoup moins de contraintes technologiques que celles qui sont connues pour augmenter la vitesse des circuits DCFL classiques.

La réalisation de bascules synchonisables DCFL est une des applications les plus intéressantes du limiteur d'excursion de tensions selon l'invention.

On sait que l'utilisation de transistors bigrilles permet de réaliser des bascules $RST\overline{T}$ les plus rapides parmi toutes les bascules synchonisables. Les bascules $RST\overline{T}$ sont des bascules RST fonctionnant avec deux horloges qui fournissent les signaux T et $\overline{T}$: elles sont aussi appelées bascules AND-NOR aux USA.

A cause de la résistance plus élevée des deux grilles en série dans un transistor bigrille, pour une tension d'alimentation $V_{DD}$ donnée, la résistance $R_{on}$ du transistor à l'état passant est sensiblement deux fois du $R_{on}$ d'un transistor monogrille, et le courant de charge $I_C$ doit être sensiblement la moitié de celui qui traverse un transistor monogrille: ceci diminue les performances des circuits DCFL, avec transistors bigrilles.

Cette diminution des courants de charge est compensée, avec le limiteur d'excursion selon l'invention, par la diminution, de l'excursion logique, ce qui diminue, comme on l'a vu, le temps de basculement et donc augmente la vitesse du circuit logique.

La figure 4 représente une bascule $RST\overline{T}$ munie de limiteurs d'excursion de tensions selon l'invention. Sur cette figure, le rectangle 26 en ligne pointillée encadre une bascule $RST\overline{T}$ classique, à un détail près: si cette bascule n'était pas munie de deux limiteurs selon l'invention, les transistors qui la composent seraient alimentés à partir d'une tension $V_{DD}$ à travers deux résistances 27 et 28 qui sont représentées en pointillés.

Cette bascule a deux entrées R et S (Reset et Set), deux sorties Q et $\overline{Q}$, et elle est commandée par deux horloges T et $\overline{T}$. Sur ses deux sorties Q et $\overline{Q}$ sont adaptés deux circuits limiteurs d'excursion de tensions selon l'invention. Sur la sortie Q est monté un premier limiteur formé par une résistance de charge 21 et un transistor 22, connectés de telle façon que le point commun 12 à la résistance 21 et au transistor 22, en lequel existe une tension qui a été précédemment dénommée $V_{12}$, est confondu avec la sortie Q de la bascule. De la même façon, sur la sortie $\overline{Q}$ est monté un second limiteur, formé par une résistance 24 et un transistor 25, et le point commun 17 est confondu avec la sortie $\overline{Q}$ de la bascule.

Les résistances 21 et 24 remplacent, respectivement, les résistances 27 et 28 d'alimentation de la bascule selon l'art connu.

Du fait que les sorties Q et $\overline{Q}$ sont connectées aux points 12 et 17, les niveaux de sorties sont limités au même titre qu'est limitée la tension $V_{12}$ (ou ($V_{17}$). Les niveaux de sorties Q et $\overline{Q}$ sont compatibles avec les niveaux d'entrées R et S:

$$V_{QH} \leqslant 3V_T$$

$$V_{QB} \leqslant V_T$$

c'est-à-dire que de telles bascules $RST\overline{T}$ peuvent être montées en cascade, cependant que les signaux d'horloge T et $\overline{T}$ ont des niveaux normaux.

Du point de vue de la réalisation d'une telle bascule, ou de tout autre circuit logique muni d'au moins un limiteur d'excursion de tension, il suffit d'ajouter les deux transistors 22 et 25, connectés sur les sorties Q et $\overline{Q}$, et de calculer les résistances de charge 21 et 24 — ou 27 et 28 d'une bascule existante, ce qui revient au même — et les caractéristiques des transistors, en particulier leur transconductance $g_m$ et leur tension de seuil $V_T$, pour qu'elles répondent à la condition:

$$I_{C24} \leqslant 2g_{m25} V_T$$

équivalente à:

$$I_{C21} \leqslant 2g_{m22} V_T$$

EP 0 187 572 B1

qui entraine la limitation d'excursions de tensions logiques:

$$V_{QH} \leqslant 3V_T$$

$$V_{QB} \leqslant V_T$$

Les réalisations concernent tous les circuits logiques, mais plus particulièrement ceux pour lesquels on recherche une grande vitesse, c'est-à-dire les circuits intégrés logiques sur GaAs ou matériaux III—V.

**Revendications**

1. Circuit limiteur d'excursion des tensions logiques dans les circuits logiques directement couplés, dits DCFL, comportant, connectés en série entre une source d'alimentation ($V_{DD}$) et la masse, une résistance de charge (21) et un transistor à effet de champ (22) dont la source (10) est à la masse et dont la grille (11) est reliée au drain (12), qui constitue le point de liaison entre le circuit logique et le circuit limiteur, celui-ci étant caractérisé en ce que la résistance de charge (21) est une charge saturable constituée par un transistor sans métallisation de grille, dont le courant constant est limité à la moitié du courant maximum qui traverse le circuit logique DCFL.

2. Circuit limiteur d'excursion de tensions selon la revendication 1, caractérisé en ce que, en vue de limiter l'excursion de tensions logiques ($\Delta V$) au point commun (12) entre le charge saturable (21) et le drain du transistor (22), la charge (21) est adaptée pour que le courant $I_{C21}$ qui la traverse soit inférieur à deux fois le produit de la transconductance $g_{m22}$ par la tension de seuil $V_T$ du transistor (22):

$$I_{C21} < 2\ g_{m22} \cdot V_T$$

3. Circuit limiteur d'excursion de tensions selon la revendication 1, caractérisé en ce que, le niveau logique bas $V_B$ étant inférieur ou égal à la tension de seuil $V_T$ du transistor, le niveau logique haut $V_H$ ($V_{12}$) est inférieur ou égal à trois fois la tension de seuil:

$$V_H \simeq\ \leqslant 3V_T$$

**Patentansprüche**

1. Schaltung zur Begrenzung des Spannungshubes der Digitalspannungen in direkt gekoppelten Logikschaltungen, die als DCFL-Schaltungen bezeichnet werden, mit einem Lastwiderstand (21) und einem Feldeffekttransistor (22), die zwischen einer Spannungsquelle ($V_{DD}$) und der Masse hintereinandergeschaltet sind, wobei die Source (10) des Feldeffekttransistors (22) mit der Masse und dessen Gate (11) mit dem den Verbindungspunkt zwischen der Logikschaltung und der Begrenzungsschaltung bildenden Drain (12) verbunden sind, dadurch gekennzeichnet, daß der Lastwiderstand (21) eine sättigbare Last ist, die von einem Transistor ohne Gatemetallisierung, dessen konstanter Strom auf die Hälfte des durch die Logikschaltung DCFL fließenden Maximalstroms begrenzt ist, gebildet wird.

2. Schaltung zur Begrenzung des Spannungshubes gemäß Anspruch 1, dadurch gekennzeichnet, daß für die Begrenzung des Spannungshubes der Digitalspannungen ($\delta V$) am gemeinsamen Punkt (12) zwischen der sättigbaren Last (21) und dem Drain des Transistors (22) die Last (21) so angepaßt wird, daß der durch sie fließende Strom $I_{C21}$ kleiner als das zweifache Produkt der Transkonduktanz $g_{m22}$ mit der Schwellenspannung $V_T$ des Transistors (22) ist:

$$I_{C21} < 2\ g_{m22} \cdot V_T.$$

3. Schaltung zur Begrenzung des Spannungshubes gemäß Anspruch 1, dadurch gekennzeichnet, daß der tiefe Logikpegel $V_B$ kleiner oder gleich der Schwellenspannung $V_T$ des Transistors und der hohe Logikpegel $V_H$ ($V_{12}$) kleiner oder gleich der dreifachen Schwellenspannung ist:

$$V_H \leqslant 3\ V_T.$$

**Claims**

1. A circuit for limiting the excursions of logical voltages in directly coupled logical circuits termed DCFL circuits, comprising, connected in series between a power source ($V_{DD}$) and ground, a load resistor (21) and a field effect transistor (22) whose source (10) is grounded and whose gate (11) is connected with the drain (12) which constitutes the point of connection between the logical circuit and the limiting circuit, the latter being characterized in that the load resistor (21) is a saturable load constituted by a transistor without gate metallization, whose constant current is limited to half the maximum current which flows through the logical DCFL circuit.

7

2. The circuit for limiting excursions of voltages as claimed in claim 1, characterized in that for the purpose of limiting the excursion of logical voltages ($\Delta V$) at the common point (12) between the saturable load (21) and the drain of the transistor (22) the load (21) is adapted so that the current $I_{C21}$ through it is less than twice the product of the transconductance $g_{m22}$ and the threshold voltage $V_T$ of the transistor (22):

$$I_{C21} < 2g_{m22} \cdot V_T.$$

3. The circuit for limiting excursions of voltages as claimed in claim 1, characterized in that when the low logical level $V_B$ is less than or equal to the threshold voltage $V_T$ of the transistor, the high logical level $V_H$ ($V_{12}$) is less than or equal to three times the threshold voltage:

$$V_H \leqslant 3V_T.$$

# FIG_1

# FIG_3

# FIG_2

# FIG_4